**Europäisches Patentamt**

**European Patent Office**

**Office européen des brevets**

(11) Veröffentlichungsnummer : **0 472 846 B1**

(12) **EUROPÄISCHE PATENTSCHRIFT**

(45) Veröffentlichungstag der Patentschrift :
**11.01.95 Patentblatt 95/02**

(51) Int. Cl.⁶ : **H03H 7/48**

(21) Anmeldenummer : **91110329.9**

(22) Anmeldetag : **22.06.91**

(54) **HF-Verteileinrichtung.**

(30) Priorität : **28.07.90 DE 4024023**

(43) Veröffentlichungstag der Anmeldung :
**04.03.92 Patentblatt 92/10**

(45) Bekanntmachung des Hinweises auf die
Patenterteilung :
**11.01.95 Patentblatt 95/02**

(84) Benannte Vertragsstaaten :
**AT BE CH DE DK ES FR GB IT LI NL SE**

(56) Entgegenhaltungen :
**EP-A- 0 134 950**
**EP-A- 0 151 784**
**WO-A-81/03588**

(73) Patentinhaber : **Richard Hirschmann GmbH &
Co.**
**Postfach 110**
**D-73726 Esslingen (DE)**

(72) Erfinder : **Wendel, Wolfgang**
**Steinbruchstrasse 62**
**W-7316 Köngen (DE)**
Erfinder : **Epple, Ralf**
**Lessingstrasse 17**
**W-7314 Wernau (DE)**

(74) Vertreter : **Stadler, Heinz, Dipl.-Ing.**
**Richard Hirschmann GmbH & Co.,**
**Postfach 1 10**
**D-73726 Esslingen (DE)**

**Beschreibung**

Die Erfindung betrifft eine Einrichtung zum Aufteilen von Hochfrequenzenergie gemäß dem Oberbegriff des Anspruches 1.

Ein derartiger Zweifachverteiler ist aus der DE 34 05 113 C2 (= EP-A- 0 151 784) bekannt. Durch entsprechende Wahl des Anschlußpunktes am Anpaßübertrager sowie der Größe des ohmschen Entkopplungswiderstandes ist es mit dieser Schaltung möglich, eine den Forderungen der deutschen Bundespost gemäß der Richtlinie 1R8-15 für BK-Anlagen genügende Entkopplung der beiden TV-Ausgänge (Koppeldämpfung zwischen benachbarten Dosenanschlüssen ≧ 40 dB im Frequenzbereich 47 bis 300 MHz) zu erzielen.

Für Anwendungen im gesamten VHF-/UHF-Bereich (47 bis 860 MHz) ist jedoch mit dieser Lösung entweder bei tiefen oder bei hohen Frequenzen dieser Wert nicht erreichbar.

Überdies kommt bei einem Einsatz des Verteilers in Antennensteckdosen in zunehmenden Maße die weitere Forderung der Richtlinie 1R8-15, wonach zwischen benachbarten Dosenanschlüssen unterschiedlicher Frequenzbereiche, nämliche RF und TV, im RF-Bereich eine Koppeldämpfung von ≧ 50 dB und im TV-Bereich von ≧ 46 dB einzuhalten ist, zum Tragen, weil anstelle der seither dem Verteiler nachgeschalteten Selektionsmittel vermehrt Breitbandverteiler eingesetzt oder gar Enddosen an die Ausgänge des Stammverteilers direkt angeschlossen werden, so daß dieser bereits den gesamten Entkopplungswert, mindestens aber abzüglich der Verteildämpfung eines nachgeschalteten Verteilers aufweisen muß.

Die Einsatzmöglichkeiten der bekannten Verteileinrichtung sind damit, insbesondere für zukünftige Anwendungen, stark eingeschränkt.

Der Erfindung liegt daher die Aufgabe zugrunde, eine Hochfrequenz-Verteileinrichtung nach dem Oberbegriff des Anspruches 1 derart weiterzubilden, daß breitbandig (VHF/UHF) eine möglichst absolute Entkopplung der beiden Ausgänge, mindestens aber eine Koppeldämpfung von ≧ 50 dB im UKW-Bereich und noch ≧ 46 dB in den TV-Bereichen oberhalb 108 MHz gewährleistet ist.

Diese Aufgabe ist durch die Merkmale des Anspruches 1 gelöst.

Durch die erfindungsgemäße Kompensation ist es möglich, den den komplexen Widerstand durchfließenden frequenzabhängigen Kompensationsstrom derart zu bestimmen, daß breitbandig an einem bzw. am hochohmigeren Ausgang zumindest annähernd die Spannung Null (unendlich hohe Koppeldämpfung) bewirkt ist, wenn der Verteilereingang wellenwiderstandsrichtig abgeschlossen und am anderen bzw. am niederohmigeren Ausgang eine Spannung angelegt wird. Allerdings ist dieser Extremfall nur mit einem Netzwerk aus sehr vielen Wirk- und Blindwiderständen realisierbar, welches nicht nur empirisch und rechnerisch schwer zu bestimmen ist, sondern für praktische Schaltungen in der Regel auch aus wirtschaftlichen Gründen nicht in Betracht kommt.

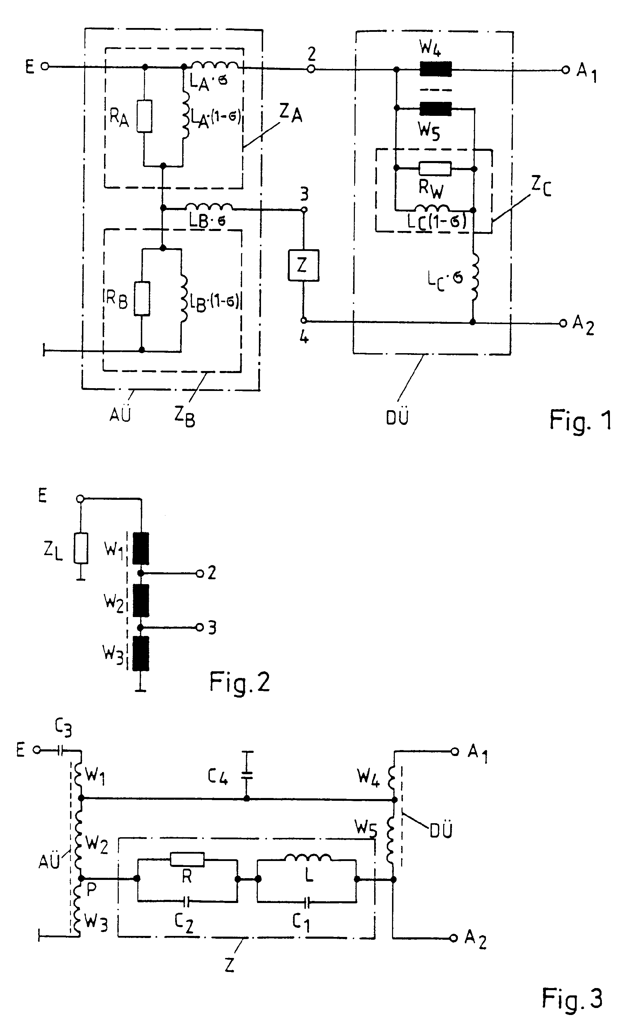

Eine Berechnung des für eine theoretisch unendliche hohe Koppeldämpfung erforderlichen komplexen Widerstandes ist mit Hilfe des Ersatzschaltbildes gemäß Figur 1 möglich, aus der sich letztendlich folgende Formel ergibt:

$$Z = X + jY = n_1 \cdot Z_B \cdot \frac{Z_A + Z_C + j\omega\sigma L_C}{Z_C - n_1(Z_A + Z_B)} - j\omega\sigma L_B$$

(Für die rechnerische Ableitung dieser Formel ist zunächst der Anpaßübertrager gem. Fig. 1 durch Transformation aus der Fig. 2 ermittelt worden). Dabei sind die folgenden Abkürzungen verwendet:

$$Z_A = \frac{R_A \cdot j\omega(1 - \sigma)L_A}{R_A + j\omega(1 - \sigma)L_A} + j\omega\sigma L_A$$

$$Z_B = \frac{R_B \cdot j\omega(1 - \sigma)L_B}{R_B + j\omega(1 - \sigma)L_B} \qquad Z_C = \frac{R_W \cdot j\omega(1 - \sigma)L_C}{R_W + j\omega(1 - \sigma)L_C}$$

$$R_A = n_2^2 \cdot \frac{Z_L}{1 + \frac{Z_L}{R_V}} \qquad R_B = n_3^2 \cdot \frac{Z_L}{1 + \frac{Z_L}{R_V}}$$

$$L_A = n_2^2 \cdot L_1; \qquad L_B = n_3^2 \cdot L_1$$

Darin bedeuten:

$$n_1 = \frac{w_5}{w_4}; \quad n_2 = \frac{1}{w} \cdot \sqrt{w_2^2 + 2w_2 w_3}; \quad n_3 = \frac{w_3}{w}$$

$w_1, w_2, w_3$      die Windungszahlen der drei Teilwicklungen $W_1$, $W_2$, $W_3$ des Anpaßübertragers

$$w = w_1 + w_2 + w_3$$

$w_4, w_5$      die Windungszahlen der beiden Teilwicklungen $W_4$, $W_5$ des Differentialübertragers (s. Fig. 1)

$Z_L$      den Wellenwiderstand

$R_V, R_W$      die Verlustwiderstände von Anpaß- und Differentialübertrager

$\sigma$      den näherungsweise als frequenzunabhängig und für beide Übertrager gleich angenommenen Streufaktor, was bei Verwendung von in Drucktechnik aufgebauten Übertragern zulässig ist.

Aus gemessenen, frequenzabhängigen Impedanzwerten realer Anpaß- und Differentialübetrager ist der Frequenzverlauf der Verlustwiderstände und Hauptinduktivitäten zu berechnen. Die Windungszahlen sind nach realisierbaren, praktischen Gegebenheiten und Erfahrungswerten vorgegebenen. Damit ist es bei gemessenen oder als Parameter angenommenen Werten für die Streuinduktivität möglich, aus den genannten Gleichungen den jeweils frequenzabhängigen Verlauf von X und Y zu errechnen.

Dies ist auch auf besonders praktikable und exakte Art durch folgendes Verfahren möglich:

Bei der Schaltung gemäß Fig. 1 ohne den komplexen Widerstand Z wird der Eingang E und der Ausgang $A_2$ wellenwiderstandsrichtig abgeschlossen, am Ausgang $A_1$ eine Spannung U angelegt und jeweils die Spannung $U_1 \cdot e^{j\varphi\,1}$ sowie $U_2 \cdot e^{j\varphi\,2}$ an den leerlaufenden Schaltungspunkten 3 und 4 gemessen. Anschließend wird der Ausgang $A_1$ wellenwiderstandsrichtig abgeschlossen und die Impedanz $Z_1$, $Z_2$ an den Schaltungspunkten 3 und 4 gemessen.

Die Impedanz Z = X + jY ergibt sich dann aus folgender Gleichung:

$$Z = X + jY = -(Z_1 + Z_2 \cdot \frac{U_1}{U_2} \cdot e^{j(\varphi 1 - \varphi 2)})$$

Diese Sollkurvenverläufe lassen prinzipiell beim Y-Wert eine Parallelresonanz bei tiefen Frequenz von etwa 1MHz, eine Serienresonanz im VHF-Bereich (mit kleiner werdenen Verlustwiderständen zu höheren Frequenzen hin) und ein Maximum etwa am oberen Ende des UHF-Bereiches erkennen. Der X-Wert bleibt bis weit in den UHF-Bereich hinein konstant und fällt dann zum oberen Ende des UHF-Bereiches etwas ab.

Aus diesen Kurvenverläufen kann zunächst eine Prinzipschaltung abgeleitet werden, die dann schrittweise verbessert wird, bis sich die Frequenzverläufe von Real- und Imaginärteil der Impedanz Z des Entkopplungsnetzwerkes den Soll-Kurvenverläufen möglichst weitgehend angenähert hat. Dies kann beispielsweise mit Rechenprogrammen erfolgen.

Die Annäherung und damit der Aufwand an Bauteilen des komplexen Widerstandes ist abhängig von den gewünschten Werten für Entkopplung und Bandbreite sowie den maximalen Kosten. Mit einem Netzwerk gemäß Anspruch 2 (Prinzipschaltung) ist ein günstiger Kompriß zwischen Aufwand, Bandbreite und Entkopplung erreicht. Mit einem lediglich vier Bauteile umfassenden Kompensationsnetzwerk ist eine Entkopplung der Ausgänge von $\geq$ 50 dB im UKW-Bereich und $\geq$ 46 dB bis 860 MHz erzielbar.

Ein Minimalaufwand ist bei einer Ausführung gemäß Anspruch 3 erreicht, mit der die Koppeldämpfung von $\geq$ 50 dB im gesamten VHF-Bereich, also insbesondere auch bei UKW, gewährleistet werden kann. Die hierfür ausreichende Kompensationswirkung kommt dadurch zustande, daß der ohmsche Widerstand und die Kapazität reale Bauteile mit Verlustwiderständen, Streuinduktivitäten und Anschlußkapazitäten sind.

Bei Verwendung von in Drucktechnik aufgebauten Übertragern, insbesondere nach dem europäischen Patent 0 134 950, kann in vorteilhafter Weise stets der hinsichtlich hoher Entkopplung optimale Anschlußpunkt gewählt werden, was bei gewickelten Übertragern häufig nicht der Fall ist. Außerdem wird die gewählte Kompensation wegen der geringen Fertigungtoleranzen und der guten Reproduzierbarkeit solcher Übertrager auch in der Serienfertigung eingehalten.

In den Figuren ist ein für den Einsatz in Antennensteckdosen vorgesehenes Ausführungsbeispiel der erfindungsgemäßen Hochfrequenz-Verteileinrichtung angebenen. Es zeigen:

Fig. 1    ein Ersatz-Prinzipschaltbild der Verteileinrichtung mit Verlustwiderständen und Streuinduktivitäten,

Fig.2    ein Ersatz-Schaltbild des Anpaßübertragers, ohne Verlustwiderstände und Streuinduktivitäten, aus dem die Teilwicklungen ersichtlich sind und das als Ausgangspunkt für das entsprechende, durch Transformation ermittelte Ersatzschaltbild in Fig. 1 dient und

Fig. 3    ein Schaltbild der Hochfrequenz-Verteileinrichtung.

Die Zweifachverteileinrichtung weist einen zwischen einem Eingang E und Masse liegenden Anpaßübertrager AÜ sowie einen die Hochfrequenzenergie auf zwei Ausgänge $A_1$, $A_2$ ungleichmäßig aufteilenden Differentialübertrager DÜ auf. Beide Übertrager sind zur Vermeidung unnötiger Verluste in an sich bekannter Weise als Sparübertrager mit in Rohrkernen verlaufenden, gemäß dem europäischen Patent 01 34 950 in Drucktechnik ausgeführten Wicklungen $W_1$ bis $W_5$ kleiner Windungszahl ausgeführt.

Der Ausgang $A_1$ mit der geringeren Verteildämpfung ist zum Anschluß des Einganges einer nicht dargestellten gleichen Verteileinrichtung einer weiteren Antennensteckdose vorgesehen, der hochohmigere Ausgang $A_2$ zum Anschluß eines nachgeschalteten, nicht dargestellten Breitbandverteilers, dessen beide Ausgänge den RF- und TV-Anschluß der Antennensteckdose bilden.

Zur Verbesserung der Rückflußdämpfung bei tiefen Frequenzen ist zwischen den Eingang E und den Anpaßübertrager AÜ ein Kondensator $C_3$ eingeschaltet. Ein eine Verbindungsleitung zwischen den beiden Anzapfpunkten der Übertrager AÜ, DÜ mit Masse verbindender Kondensator $C_4$ bewirkt in bekannter Weise eine Erhöhung der oberen Grenzfrequenz.

Zur breitbandigen Verbesserung der Koppeldämpfung zwischen den Verteilerausgängen $A_1$ und $A_2$ im gesamten Betriebsfrequenzbereich von 47 bis 860 MHz ist zwischen den hochohmigeren Ausgang $A_2$ und einem Anschlußpunkt P des Anpaßübertragers AÜ ein Entkopplungsnetzwerk Z eingeschaltet, das aus der Serienschaltung eines eine Spule L und einen ersten Kondensator $C_1$ aufweisenden Parallelresonanzkreises und der Parallelschaltung eines ohmschen Widerstandes R mit einem zweiten Kondensator $C_2$ besteht. Mit diesem aus nur vier Bauelementen gebildeten Netzwerk zur Kompensation der Verlustwiderstände und Blindkomponenten der beiden Übertrager AÜ, DÜ wird ein diese Schaltung durchfließender Kompensationsstrom erzeugt, der nicht nur eine hohe Entkopplung der beiden Ausgänge $A_1$, $A_2$ voneinander bewirkt, sondern zugleich als der an sich zu hohen Impedanz des Ausganges $A_2$ parallel geschalteter Widerstand dessen Rückflußdämpfung verbessert.

Durch die Wahl der Bauteilewerte (R = 33 Ω, L = 0,2 μH, $C_1$ = 3,9 nF und $C_2$ = 5,1 pF) ist eine Koppeldämpfung zwischen den beiden Ausgängen $A_1$, $A_2$ von $\geqq$ 50 dB bei UKW und noch $\geqq$ 46 dB in den TV-Bereichen 3 bis 5 erreicht. Damit ist die Forderung gemäß der genannten Bundespost-Richtlinie 1R8-15 selbst dann noch erfüllt, wenn dem erfindungsgemäßen Verteiler weder frequenzselektive Mittel noch Breitbandverteiler nachgeschaltet, sondern an den Ausgang $A_2$ von in der Stammleitung hintereinander geschalteten erfindungsgemäßen Verteileinrichtung jeweils eine Enddose direkt angeschlossen ist.

Diese günstigen Werte werden ohne besondere Abgleichmaßnahmen auch in der Serienfertigung eingehalten, insbesondere deshalb, weil die beiden Übertrager AÜ, DÜ in Drucktechnik ausgeführt sind und dadurch äußerst geringe Fertigungstoleranzen aufweisen und keine besonderen Maßnahmen zur Herstellung von Anzapfpunkten erfordern.

Mit dem beschriebenen Aufbau ist ein günstiger Kompromiß zwischen Bauteileaufwand, Bandbreite und Entkopplung erreicht. Sofern jedoch im Einzelfall noch höhere Werte für die Bandbreite und/oder Entkopplung gefordert werden, so ist dies mit komplizierteren Netzwerken möglich. Zur Ermittlung des Netzwerksaufbaus wird dazu zunächst sein komplexer Widerstand Z aus einer der oben angegebenen Formeln errechnet, wobei von praktischen Erfahrungswerten für die Windungszahlen der Übertrager und der Streuinduktivitäten ausgegangen und bei der ersten Formel vorausgesetzt wird, daß der Streufaktor für alle Übertragerwicklungen gleich und frequenzunabhängig ist. Bei komplizierteren Netzwerken zur Erzielung noch höherer Bandbreiten und-/oder Entkopplungen genügen diese Vereinfachungen nicht mehr; in diesen Fällen sind die vorgenannten Größen entweder zu messen, oder als veränderliche Parameter in die Rechnung einzuführen.

Als zweiter Schritt wird aus dem Sollfrequenzgang von Real- und Imaginärteil des komplexen Widerstandes Z eine Grundschaltung für das Netzwerk ermittelt, wie sie im vorliegenden Ausführungsbeispiel gemäß Fig. 3 vorliegt, deren Bauteilewerte durch optimale Annäherung ihres Frequenzgangs an den Sollfrequenzgang z.B. mit Hilfe eines Rechenprogramms bestimmt werden.

Mit durch zusätzliche Bauelemente erweiterten Grundschaltungen ist - ebenfalls mittels Rechenprogrammen - durch Variation der Bauteilewerte eine weitere Annäherung an den genannten Sollfrequenzgang möglich, wobei allerdings der Aufwand sowohl hinsichtlich der Ermittlung solcher Schaltungen als auch deren Kosten mit zunehmenden Forderungen und damit wachsender Komplexität überproportional ansteigt.

## Patentansprüche

1.  Einrichtung zum Aufteilen von Hochfrequenzenergie im VHF-/UHF-Bereich auf zwei voneinander entkoppelte Ausgänge ($A_1$,$A_2$), mit je einem jeweils eine Wicklung mit Anzapfung aufweisenden Anpaß- und Differentialübertrager (AÜ,DÜ), wobei die Anzapfungen miteinander leitend verbunden sind, sowie einem zwischen einem zur Erzielung größtmöglicher Entkopplung optimalen Anschlußpunkt des Anpaßübertragers (AÜ) und bei symmetrischer Verteilung einem der beiden Ausgänge bzw. bei unsymmetrischer Verteilung dem hochohmigeren Ausgang eingeschalteten Entkopplungswiderstand (Z),
    dadurch gekennzeichnet, daß der Entkopplungswiderstand ein komplexer Widerstand Z = X + jY ist, dessen frequenzabhängige, den erforderlichen ohmschen Entkopplungswiderstand bildende Resistanz X die Verlustwiderstände und dessen Reaktanz Y die Haupt- und Streuinduktivitäten der beiden Übertrager (AÜ, DÜ) breitbandig kompensiert.

2.  Einrichtung nach Anspruch 1, dadurch gekennzeichnet, daß der komplexe Widerstand (Z) durch eine Serienschaltung eines eine Spule (L) und einen ersten Kondensator ($C_1$) aufweisenden Parallelresonanzkreises und der Parallelschaltung eines ohmschen Widerstandes (R) mit einem zweiten Kondensator ($C_2$) gebildet ist.

3.  Einrichtung nach Anspruch 1, dadurch gekennzeichnet, daß der komplexe Widerstand aus der Serienschaltung eines ohmschen Widerstandes und eines Kondensators besteht.

4. Einrichtung nach einem der Ansprüche 1 bis 3, dadurch gekennzeichnet, daß die beiden Übertrager (AÜ, DÜ) in Drucktechnik aufgebaut sind.

## Claims

1. High-frequency distribution network for subdividing a high-frequency energy within the UHF/VHF range onto two outputs ($A_1$, $A_2$) being mutually decoupled, with one adaptive and one differential transmitter ($A_Ü$, $D_Ü$) each, providing one winding with one pick-up each, the pick-ups being electrically connected, as well as an ohmic decoupling resistance (Z) being located in between an optimum connecting point of the adaptive transmitter ($A_Ü$) on the one hand and, with symmetric distribution, one of the two outputs or, with asymmetric distribution, the output providing the respectively higher ohmic resistance on the other hand, in order to achieve a decoupling effect as high as possible, in such a way characterised that the decoupling resistance is a complex resistance $Z = X + jY$ whose frequency dependent partial resistance providing the required ohmic decoupling resistance Z in broad range compensates for the ohmic resistances and whose reactance Y in broad range compensates for the main and the parasitic inductances of the two transmitters ($A_Ü$, $D_Ü$).

2. High-frequency distribution network according to claim 1, in such a way characterised that the complex resistance (Z) is achieved by connecting in series a parallel resonance circuit providing a coil (L) and a first capacitor ($C_1$) and by connecting in parallel of an ohmic resistance (R) with a second capacitor ($C_2$).

3. High-frequency distribution network according to claim 1, in such a way characterised that the complex resistance consists of connecting in series an ohmic resistance and a capacitor.

4. High-frequency distribution network according to one of the claims 1 to 3, in such a way characterised that the two transmitters ($A_Ü$, $D_Ü$) are made in printed circuit technology.

## Revendications

1. Dispositif de distribution à hautes fréquences à fin de subdiviser une énergie haute fréquence dans la gamme U.H.F./V.H.F. pour l'alimenter aux deux sorties ($A_1$, $A_2$) étant, à leur part, découplées l'un de l'autre, chacun avec un transmetteur adaptive et différentiel ($A_Ü$, $D_Ü$), chacun d'eux possédant un bobinage avec un soutirage, les soutirages étant en communication, et une résistance découpleur ohmique (Z) localisé entre un point d'interconnexion optimal du transmetteur adaptive ($A_Ü$) et, en cas de distribution symétrique, l'une des deux sorties ou, en cas de distribution asymétrique, la sortie ayant la résistance ohmique la plus haute, à fin d'achever un effet de découplage le plus haut que possible, caractérisé par les faits que la résistance de découplage consiste d'une résistance complexe $Z = X + jY$, la résistance partielle dépendant de la fréquence étant la résistance découpleur ohmique Z nécessaire à compenser à large bande les resistances ohmiques, et la réactance Y à compenser les inductances principales et parasites des deux transmetteurs ($A_Ü$, $D_Ü$).

2. Dispositif de distribution à hautes fréquences selon revendication 1, caractérisé par le fait que la résistance complexe (Z) est achevée par connexion en série d'un circuit de résonance parallèle se composant d'une bobine (L) et d'un premier condensateur ($C_1$) et par connexion en parallèle d'une résistance ohmique (R) avec un second condensateur ($C_2$).

3. Dispositif de distribution à hautes fréquences selon revendication 1, caractérisé par le fait que la résistance complexe consiste de la connexion en série d'une résistance ohmique et d'un condensateur.

4. Dispositif de distribution à hautes fréquences selon une ou plusieurs des revendications 1 à 3, caractérisé par le fait que les deux transmetteurs ($A_Ü$, $D_Ü$) sont construit en technologie de circuit imprimé.

Fig. 1

Fig.2

Fig.3